Europäisches Patentamt

European Patent Office

Office européen des brevets

(11) Veröffentlichungsnummer: **0 276 386 B1**

# (12) EUROPÄISCHE PATENTSCHRIFT

(45) Veröffentlichungstag der Patentschrift: 31.07.91          (51) Int. Cl.⁵: **B23K 1/08**

(21) Anmeldenummer: **87116620.3**

(22) Anmeldetag: **11.11.87**

(54) **Verfahren zum Aufbringen einer Lotschicht auf metallische oder metallisierte Flächen von Bauelementen.**

(30) Priorität: **15.12.86 CH 4976/86**

(43) Veröffentlichungstag der Anmeldung:
**03.08.88 Patentblatt 88/31**

(45) Bekanntmachung des Hinweises auf die
Patenterteilung:
**31.07.91 Patentblatt 91/31**

(84) Benannte Vertragsstaaten:
**AT BE CH DE ES FR GB IT LI NL SE**

(56) Entgegenhaltungen:
**EP-A- 0 078 900**
**EP-A- 0 119 157**
**DE-B- 1 223 667**
**US-A- 3 092 059**
**US-A- 4 538 757**

(73) Patentinhaber: **SIEMENS-ALBIS AKTIENGE-
SELLSCHAFT**
**PV/Patente und Verträge Postfach**
**CH-8047 Zürich(CH)**

(72) Erfinder: **Bajka, Imre**
**Geeringstrasse 35**
**CH-8049 Zürich(CH)**
Erfinder: **Lieberherr, Rolf**
**Obsthaldenstrasse 185**
**CH-8046 Zürich(CH)**

## Beschreibung

Die vorliegende Erfindung betrifft ein Verfahren gemäss dem Oberbegriff des Patent-anspruchs 1, sowie eine Vorrichtung zu dessen Durchführung gemäss Patentanspruch 5.

Bei der Herstellung von Leiterplatten für gedruckte Schaltungen ist es vorteilhaft, alle metallischen Flächen mit einer schützenden lötbaren Beschichtung zu versehen, um damit die Löt- und Lagerhaltungseigenschaften der Platten zu verbessern. Dies kann durch Eintauchen der Platten in flüssiges Lot geschehen. Eine diesem Zweck dienende Vorrichtung ist beispielsweise aus der EP-B1-0 078 900 bekannt, bei der die Platte horizontal durch einen Schwall flüssigen Lotes hindurchgeschoben wird. Dabei zeigt sich, dass nicht alle nicht durchkontaktierten metallischen Flächen, d.h. Kupferflächen, die kein Bohrloch aufweisen (wie z.B. kleine Kontaktflächen für SMD-Bauteile oder relativ kleinflächige Prüfpunkte), beim ersten Durchlauf mit Lot beaufschlagt werden. Bei mit einem Lötstopfilm (Vacrel-Folie) abgedeckten Platten ist diese Erscheinung noch ausgeprägter. Daher ist es oft erforderlich, solche Platten mehrmals mit dem flüssigen Lot in Verbindung zu bringen, was einen erhöhten Fertigungsaufwand bedeutet. Die zum Teil auftretende mangelhafte Lotbeschichtung der metallischen Flächen dürfte darauf zurückzuführen sein, dass die auf die Flächen einwirkende Wärme vor dem Zusammentreffen der Flächen mit dem flüssigen Lot eine Verdunstung des Flussmittels bewirkt und sich daher auf den Flächen eine Oxydschicht bildet, welche die anschliessende Benetzung mit dem Lot erschwert oder gar verhindert.

Aehnliche Probleme können auch in anderen Fällen auftreten, wo es erforderlich ist, Lot auf metallische oder metallisierte Flächen aufzubringen, wie beispielsweise beim Verlöten von Anschlüssen auf den relativ kleinen Anschlussflächen von Substraten für Hybridschaltungen. Unter Eintauchen in das Lot soll im vorliegenden Zusammenhang nicht nur das vertikale Eintauchen, sondern auch das Eintauchen in einem beliebigen Winkel sowie der in der erwähnten Vorrichtung stattfindende horizontale Durchlauf verstanden werden.

Aus der DE-B-1 223 667 ist eine Vorrichtung zum Schwallöten von mit elektrischen Bauteilen bestückten Leiterplatten bekannt, in der die Leiterplatte vor Erreichen der Lötwelle durch Zuführung von erwärmter Druckluft oder erwärmtem Stickstoff vorgewärmt und ein Abtropfen bzw. Abfallen des Flussmittels verhindert wird. Bei Verwendung von erwärmtem Stickstoff soll zusätzlich eine Oxydation der Zuleitungen der zu verlötenden Bauteile verhindert werden. Diese Vorrichtung ermöglicht ein Verlöten der Bauteileanschlüsse auf der Leiterplattenunterseite; das eingangs erwähnte Beschichten von metallischen Flächen auf einer oder auf beiden Seiten der Leiterplatte mit Lot ist bei dieser Vorrichtung nicht vorgesehen.

Der vorliegenden Erfindung liegt daher die Aufgabe zugrunde, ein Verfahren der eingangs genannten Art anzugeben, das eine zuverlässige und qualitativ einwandfreie Lotbeschichtung sämtlicher beteiligter metallisierten oder metallischen Flächen beim erstmaligen Eintauchen in das Lot gewährleistet. Die Lösung dieser Aufgabe gelingt mit einem Verfahren, wie es im Patentanspruch 1 gekennzeichnet ist. Weiterbildungen und eine Vorrichtung zur Durchführung des Verfahrens sind in weiteren Ansprüchen angegeben.

Die Erfindung wird nachfolgend anhand einer Zeichnung beispielsweise näher erläutert.

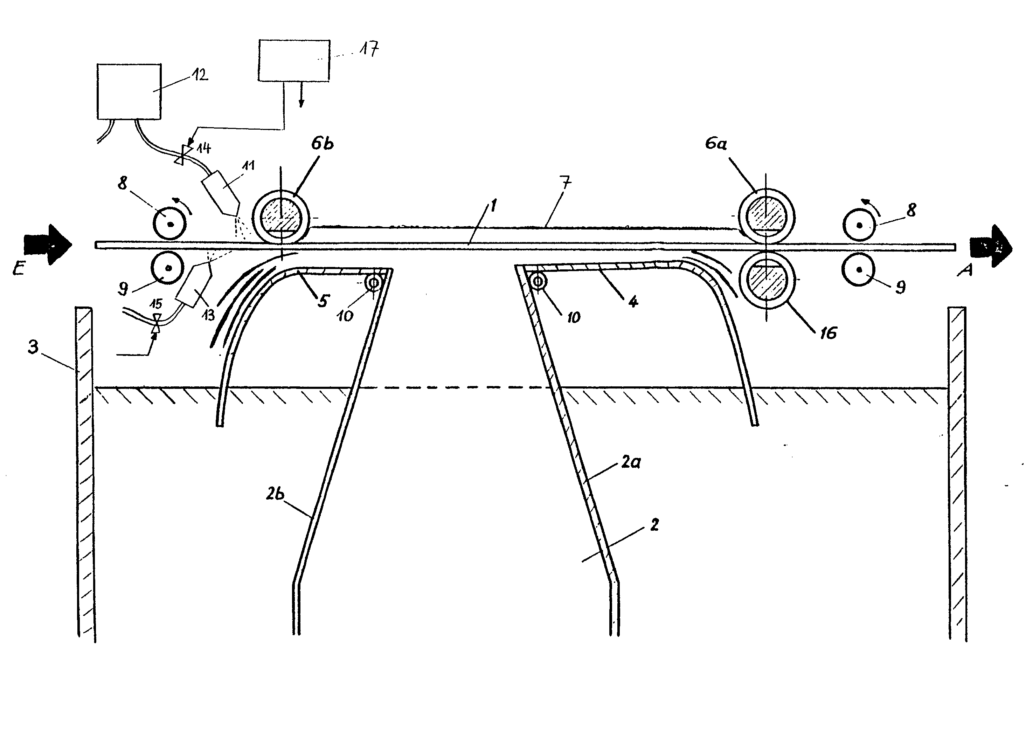

Die Figur zeigt die aus der eingangs erwähnten EP-B1-0 078 900 bekannte Vorrichtung, in der das erfindungsgemässe Verfahren beispielsweise anwendbar ist. Diese Vorrichtung wird hier nur soweit beschrieben, wie dies zur Erläuterung des Verfahrens unbedingt notwendig ist.

Die Vorrichtung weist einen Vorratsbehälter 3 auf, der geschmolzenes Lot enthält, das mittels einer Heizung auf der notwendigen Temperatur gehalten wird. Darin befindet sich ein aus dem Lotbad herausragender, nach oben kaminförmig ausgebildeter Aufbau 2. Sowohl der Aufbau 2 als auch der Vorratsbehälter 3 sind nur teilweise dargestellt. Die Vorschub- bzw. Fortbewegungsebene der beidseitig mit einer Lotschicht zu beaufschlagenden Schaltungsplatte 1 befindet sich in einem bestimmten Abstand über der Oeffnung des Aufbaus 2. Die zuvor beidseitig mit einem Flussmittel benetzte und vorgewärmte Schaltungsplatte 1 wird von der Eintrittsseite E her mit einer bestimmten Geschwindigkeit in Richtung Austrittsseite A transportiert. Die Fortbewegung der Schaltungsplatte 1 kann mit an sich in diesem Zusammenhang bekannten Fördermitteln, beispielsweise mit Walzenpaaren 8, 9 erfolgen, wobei vorzugsweise je eine Walze eines Paares gleichförmig angetrieben ist. Dabei können sich die Walzen über die gesamte Breite der Schaltungsplatte 1 erstrecken oder aber die Schaltungsplatte 1 nur teilweise, z.B. im Randbereich, erfassen. Zwecks Anpassung an unterschiedliche Plattendicken ist wenigstens eine der beiden Walzen eines Paares senkrecht zur Vorschubebene verschiebbar angeordnet.

Am oberen Rand derjenigen Seitenwände 2a, 2b des Aufbaus 2, die quer zur Vorschubrichtung der Schaltungsplatte 1 verlaufen, ist je ein Leitblech 4 bzw. 5 drehbar angebracht. Dessen Breite entspricht in etwa der Breite der zugehörigen Seitenwand. Die Oeffnung des kaminartigen Aufbaus 2 ist in Querrichtung mindestens so lang, vorzugsweise wie im vorliegenden Beispiel jedoch länger wie die grösste Breite der zu bearbeitenden Schaltungsplatten 1. Die Leitblechebene verläuft annähernd parallel zur Vorschubebene der Schaltungsplatte 1. Die Enden der Leitbleche 4, 5 sind vorzugsweise nach unten, d.h. gegen das Innere des Vorratsbehälters 3 hin abgebogen, um ein sauberes Zurückfliessen des Lotes in den Vorratsbehälter 3 zu gewährleisten. Der Neigungswinkel der Leitbleche 4, 5 bezüglich der Vorschubebene der Schaltungsplatte 1 ist mittels entlang den Seitenwänden 2a, 2b nach oben und nach unten verschiebbaren Arretierungen 10 wahlweise einstellbar. Dadurch lässt sich die Grösse dès Zwischenraumes zwischen den Leitblechen 4, 5 und der Schaltungsplatte 1 beliebig verändern. Zudem ist der Vorratsbehälter 3 gemeinsam mit dem Aufbau 2 in vertikaler Richtung relativ zur Vorschubebene verschiebbar.

Unmittelbar über der Vorschubebene der Schaltungsplatte 1 sind über oder zumindest in der Nähe der Biegestelle der Leitbleche 4, 5 quer, beispielsweise senkrecht zur Vorschubrichtung verlaufende zylinderförmige Elemente 6a, 6b angeordnet. Das im Bereich der Eintrittsstelle E der Schaltungsplatte 1 über dem Lotschwall angeordnete Element 6b dient der Begrenzung des sich beim Betrieb der Vorrichtung auf der Plattenoberseite bildenden Lotteppichs 7, während das andere Element 6a neben der Begrenzung des Lotteppichs 7 auf der Ausgangsseite A zusätzlich die Abstreifung des Lotes und eines Teils der Flussmittelreste auf der die Vorrichtung verlassenden Schaltungsplatte 1 übernimmt.

Auf der Eintrittsseite E ist zwischen der oberen Walze 8 und dem Element 6b quer zur Vorschubrichtung der Schaltungsplatte 1 eine über eine Leitung mit einem eine Flüssigkeit enthaltenden Behälter 12 verbundene Sprüheinrichtung 11 vorhanden, die aus einer oder mehreren Sprühdüsen besteht und deren Wirkungsbereich sich über die ganze Breite auf der Oberseite der Platte 1 erstreckt. Als Sprühdüsen sind handelsübliche Geräte einsetzbar. Die erfindungsgemäss auf die Platte 1 aufzubringende Flüssigkeit wird der Sprüheinrichtung 11 zugeführt. Zur Steuerung der Zufuhr ist in der Verbindungsleitung ein Ventil 14, z.B. ein Magnetventil, eingefügt, welches durch eine Steuereinrichtung 17 betätigt wird. Dabei kann das Ventil 14 während dem Durchlauf der Platte 1 ständig oder impulsweise geöffnet sein. Die Sprüheinrichtung 11 ist derart angeordnet, dass bei deren Betrieb jeweils ein sich vor dem Element 6b befindlicher quer verlaufender in etwa streifenförmiger Bereich auf der Schaltungsplatte 1 mit der Flüssigkeit beaufschlagt wird. Zur Optimierung des Wirkungsbereiches der Sprüheinrichtung 11 kann der Winkel der Sprühdüsen bezüglich der Vorschubebene der Platte 1 durch nicht weiter dargestellte Mittel eingestellt werden.

Falls auf der Unterseite der Platte 11 ebenfalls bezüglich des Aufbringens von Lot kritische metallische Flächen vorhanden sind, wird auf der Eintrittsseite E unter der Vorschubebene vor dem sich beim Betrieb der Vorrichtung einstellenden Lotschwall (in der Figur mit drei dicken Linien angedeutet) eine weitere Sprüheinrichtung 13 vorgesehen, die ebenfalls mit dem Flüssigkeitsbehälter 12 verbunden ist und in deren Verbindungsleitung auch ein durch die genannte Steuereinrichtung 17 betätigbares Ventil 15 eingesetzt sein kann. Die Flüssigkeit kann den Sprüheinrichtungen 11, 13 in bekannter Weise auch mittels eines Druckgases, wie z.P. Pressluft, zugeführt werden, so dass die Ventile 14, 15 entfallen können, wobei die auf die Sprüheinrichtungen wirkende Druckgasquelle von der Steuereinrichtung 17 wirksam geschaltet wird.

Sobald beim Betrieb der Vorrichtung eine zuvor in bekannter Weise mit einem Flussmittel beaufschlagte Schaltungsplatte 1 in den Bereich der Eintrittsstelle E gelangt, wird selbsttätig eine Pumpe eingeschaltet, die flüssiges Lot innerhalb des Aufbaus 2 nach oben befördert. Die Pumpe wird jeweils wieder selbsttätig ausgeschaltet, wenn die Schaltungsplatte 1 den Bereich der Austrittsstelle A verlassen hat. Das oben austretende Lot bildet über der Oeffnung einen die Vorschubebene übersteigenden Schwall, der über die Leitbleche 4, 5 abfliesst. Sobald nun die Schaltungsplatte 1 von der Eintrittsstelle E her den Bereich des Elementes 6b und des Leitbleches 5 erreicht, gelangt sie zunächst an ihrer Unterseite in Kontakt mit dem heissen Lotschwall und wird bei fortschreitendem Vorschub kontinuierlich erwärmt. Gleichzeitig wird die Sprüheinrichtung 11 - und gegebenenfalls auch die Sprüheinrichtung 13 - aktiviert und beaufschlagt die Schaltungsplatte 1 kurz vor dem Eindringen in den Lotschwall auf deren Ober- bzw. Unterseite mit der Flüssigkeit. Die wesentlichen Eigenschaften einer geeigneten Flüssigkeit sind folgende: Der Siedepunkt muss deutlich unterhalb der Temperatur des flüssigen Lotes liegen. Unter Einfluss von Wärme darf sich keine Zersetzung mit Ausscheidungen und Ablagerungen bilden. Sie darf nicht aus Elementen mit unterschiedlichen Siedepunkten zusammengesetzt sein. Schliesslich darf sie beim Aufsprühen auf die Flächen nicht in das Flussmittel eindringen.

In der Praxis hat sich die Verwendung von reinem Wasser als besonders vorteilhaft erwiesen, da es den gestellten Anforderungen vollauf gerecht wird, keine zusätzliche Umweltbelastung mit sich bringt und in Leiterplattenfertigungsstrassen ohnehin für die Nachreinigung zur Verfügung steht. Statt an einen Behälter 12 können in diesem Fall die Sprüheinrichtungen 11, 13 vorteilhafterweise auch direkt an ein Wasserversorgungssystem angeschlossen werden. Das Aufbringen von Wasser während dem Durchlauf der Platte 1 kann durch entsprechende Ansteuerung der Ventile 14, 15 durch die Steuereinrichtung 17 entweder fortwährend oder stossweise erfolgen. Das aufgesprühte Wasser verdampft sofort, sobald es mit dem heissen Lot in Kontakt gelangt, was eine Zerstörung der Lotoberfläche bewirkt, wodurch das Lot zwangsweise auf die zu beschichtenden metallischen Flächen gelangt, bevor diese infolge des verdampften Flussmittels oxydieren können. Die unerwünschte Oxydation ist gerade bei relativ kleinen Flächen mit entsprechend geringer Wärmekapazität besonders ausgeprägt. Dadurch wird die Benetzungsfreundlichkeit dieser Flächen mit Lot entscheidend verbessert. Mit dem beschriebenen Vorgehen gelingt es in einfacher Weise, sämtliche metallischen Flächen der Platte 1 in einem einzigen Durchlauf einwandfrei mit Lot zu beschichten.

Eine weitere beispielsweise Anwendungsmöglichkeit des beschriebenen Verfahrensprinzips betrifft das eingangs kurz erwähnte Anlöten von Anschlusselementen an Anschlussflächen auf Substraten bei Hybridschaltungen. Die Aussenanschlüsse der Schaltungen werden dabei meist in Form von sogenannten Anschlusskämmen direkt am Substrat befestigt, wobei der Anschlusskamm zunächst auf die Anschlussflächen aufgesteckt und anschliessend mit den Flächen verlötet wird (siehe z.B. Herbert Reichl: "Hybridintegration", Heidelberg 1986, Seite 250). Zum Verlöten ist beispielsweise ein Automat bekannt, bei dem die bestückten Substrate und die aufgesteckten Anschlusskämme in vertikaler Lage so durch eine Welle flüssigen Lotes hindurchgeführt werden, dass die Anschlusskämme bis nahe ihrer Verbindungsstelle mit den Anschlussflächen in das Lot eintauchen. Auch hier trägt das Besprühen der zuvor mit einem Flussmittel beaufschlagten Anschlussflächen des Substrates und der Drahtenden des Anschlusskammes im Bereich der Verbindungsstelle kurz vor dem Zusammentreffen mit dem flüssigen Lot zu einer erhöhten Benetzungsfreundlichkeit und damit zu einwandfreien Lötstellen bei.

Das erfindungsgemässe Verfahren lässt sich überall dort vorteilhaft einsetzen, wo zur Erzielung einer optimalen Lotbeschichtung insbesondere kleiner metallischer oder metallisierter Flächen bzw. einwandfreier Lötstellen die Benetzung verbessert werden muss, wobei es unwesentlich ist, in welcher Weise die Flächen mit dem Lot in Berührung gebracht werden, d.h. ob die Flächen vertikal oder in einem bestimmten Winkel eingetaucht oder in einem mehr oder weniger horizontalen Durchlauf mit dem Lot in Berührung gebracht werden.

**Patentansprüche**

1. Verfahren zum Aufbringen einer Lotschicht auf metallische oder metallisierte Flächen, insbesondere auf Flächen von Bauelementen (1) für elektrotechnische Anwendungen, welche Flächen nach dem Aufbringen eines Flussmittels durch Eintauchen in flüssiges Lot (7) mit dem Lot beaufschlagt werden, **dadurch gekennzeichnet**, dass die Flächen kurz vor dem Zusammentreffen mit dem flüssigen Lot (7) zusätzlich mit einer Flüssigkeit beaufschlagt werden, deren Siedepunkt unterhalb desjenigen des flüssigen Lotes (7) liegt und die nicht in das Flussmittel eindringt sondern verdampft, sobald sie mit dem Lot in Kontakt gelangt.

2. Verfahren nach Anspruch 1 zum Aufbringen einer Lotschicht auf die metallischen Flächen einer unbestückten gedruckten Schaltungsplatte (1), wobei nach dem Aufbringen eines Flussmittels auf die Platte (1) die metallischen Flächen durch Eintauchen der Platte (1) in flüssiges Lot (7) und anschliessendes Herausziehen mit dem Lot beaufschlagt werden, **dadurch gekennzeichnet**, dass der noch nicht eingetauchte Teil der Platte (1) in einem kurz vor dem Eindringen in das flüssige Lot befindlichen und sich über die ganze Breite der Platte (1) erstreckenden Bereich auf den die metallischen Flächen aufweisenden Seiten mit der Flüssigkeit beaufschlagt wird.

3. Verfahren nach Anspruch 1 zum Verbinden von metallisierten Anschlussflächen auf einem Substrat mit Anschlusselementen, wobei die Anschlusselemente zuerst mechanisch an den Flächen fixiert werden und nach dem Aufbringen eines Flussmittels die Anschlusselemente durch Eintauchen in flüssiges Lot mit den Flächen elektrisch leitend verbunden werden, **dadurch gekennzeichnet**, dass die Anschlusselemente und die Flächen kurz vor dem Zusammentreffen mit dem flüssigen Lot mit der Flüssigkeit beaufschlagt werden.

4. Verfahren nach einem der vorhergehenden Ansprüche, **dadurch gekennzeichnet**, dass als Flüssigkeit Wasser verwendet wird.

5. Vorrichtung zur Durchführung des Verfahrens nach Anspruch 2, mit einem geschmolzenes Lot enthaltenden Vorratsbehälter und einem aus diesem Vorratsbehälter ragenden kaminartigen Aufbau (2), in dessen Innerem Lot aus dem Vorratsbehälter (3) in solcher Menge nach oben befördert wird, dass sich über der Austrittsöffnung des Aufbaus (2) ein Schwall flüssigen Lotes bildet, mit dem die horizontal vorgeschobene Schaltungsplatte (1) in Berührung gebracht wird, wobei am oberen Rand wenigstens derjenigen quer zur Vorschubrichtung verlaufenden Seitenwand (2b) des Aufbaus (2), die der Eintrittsseite (E) zugewandt ist, ein Leitblech (5) angebracht ist, das zumindest teilweise annähernd parallel zu der durch den Lotschwall hindurch verlaufenden Vorschubebene der Schaltungsplatte (1) verläuft und dessen Neigungswinkel und Abstand zur Vorschubebene wahlweise einstellbar ist, wobei ferner sowohl auf der Eintritts- (E) als auch auf der Austrittsseite (A) unmittelbar über der Vorschubebene mindestens ein quer zur Vorschubrichtung der Schaltungsplatte (1) angeordnetes Element (6a, 6b) vorgesehen ist, welche Elemente (6a, 6b) beim Durchlauf der Schaltungsplatte (1) einerseits zum Abstreifen des Lotes dienen und andererseits eine Begrenzung für den auf der Oberseite der Schaltungsplatte (1) auftretenden Lotteppich bilden, **dadurch gekennzeichnet, dass,** nebst einer Einrichtung zum Aufbringen eines Flussmittels, im Bereich des eintrittseitigen Elementes (6b) wenigstens oberhalb oder unterhalb der Vorschubebene eine mit einem Anschluss zum Zuführen einer Flüssigkeit verbundene Sprüheinrichtung (11 bzw. 13) mit sich über die ganze Breite der Schaltungsplatte (1) erstreckendem Wirkungsbereich derart angeordnet ist, dass bei deren Betrieb die vorgeschobene Schaltungsplatte (1) in einem sich nahe vor dem eintrittseitigen Element (6b) befindlichen, sich über die ganze Breite der Platte (1) erstreckenden Bereich mit der Flüssigkeit besprüht wird.

6. Vorrichtung nach Anspruch 5, **dadurch gekennzeichnet,** dass eintrittseitig sowohl oberhalb als auch unterhalb der Vorschubebene eine Sprüheinrichtung (11,13) vorgesehen ist.

7. Vorrichtung nach Anspruch 5 oder 6, dass die Sprüheinrichtungen (11, 13) während des Durchlaufs der Platte (1) wahlweise entweder fortwährend oder impulsweise aktivierbar sind.

8. Vorrichtung nach einem der Ansprüche 5 bis 7, **dadurch gekennzeichnet,** dass die Aktivierung der Sprüheinrichtungen (11, 13) durch eine Steuereinrichtung (17) über in der Zuleitung eingefügte Ventile (14, 15) erfolgt.

9. Vorrichtung nach einem der Ansprüche 5 bis 7, **dadurch gekennzeichnet,** dass die Sprüheinrichtungen (11, 13) über eine Steuereinrichtung (17) mit Druckgas, z.B. Pressluft, aktivierbar sind.

10. Vorrichtung nach Anspruch 8 oder 9, **dadurch gekennzeichnet,** dass die Sprüheinrichtungen (11, 13) mit einem Anschluss zum Zuführen von Wasser verbunden sind.

## Claims

1. A method for applying a solder layer to metallic or metallised surfaces, in particular on surfaces of components (1) for electrotechnical uses, which surfaces are acted upon by the solder, after application of a fluxing agent by immersion into liquid solder (7), characterised in that the surfaces are acted upon, shortly before meeting with the liquid solder (7), additionally by a liquid, the boiling point of which lies below that of the liquid solder (7) and which does not penetrate into the fluxing agent but evaporates as soon as it comes into contact with the solder.

2. A method according to claim 1 for applying a solder layer to the metallic surfaces of an unfitted printed circuit board (1), wherein after the application of a fluxing agent onto the board (1) the metallic surfaces are acted upon by immersion of the board (1) into liquid solder (7) and subsequent extraction with the solder, characterised in that the part of the board (1) which is not yet immersed, in a region extending over the whole width of the board (1) and found shortly before penetration into the liquid solder, is acted upon on the sides having metallic surfaces by the liquid.

3. A method according to claim 1 for connecting metallised connecting surfaces of a substrate with connecting elements, wherein the connecting elements are fixed firstly mechanically to the surfaces and then after application of a fluxing agent the connecting elements are connected in an electrically conductive manner with the surfaces by immersion into liquid solder, characterised in that the connecting elements and the surfaces are acted upon with liquid shortly before meeting the liquid solder.

4. A method according to one of the preceding claims, characterised in that water is used as liquid.

5. A device for carrying out the method according to claim 2, with a supply container containing melted solder and a chimney-shaped structure (2) projecting from this supply container, in the interior of which solder is conveyed upwards from the supply container (3) in such quantities that a wave of liquid solder forms over the outlet opening of the structure (2), with which the circuit board (1), pushed forward horizontally is brought into contact, wherein on the upper edge of at least the side wall (2b) of the structure (2), extending transverse to the feed direction, which side faces the inlet side (E), there is attached a baffle (5), which extends at least partially approximately parallel to the feed plane of the circuit board (1), extending through the solder wave and the angle of inclination of which and the distance to the feed plane is able to be adjusted selectively, wherein furthermore on the inlet (E) as well as on the outlet side (A), directly above the feed plane, there is provided at least one element (6a, 6b) arranged transverse to the feed direction of the circuit board (1), which elements (6a, 6b) serve on one side during the running through of the circuit board (1), for stripping-off the solder and, on the other side, form a boundary for the solder carpet forming on the upper side of the circuit board (1), characterised in that in addition a device for applying a fluxing agent, in the region of the inlet side element (6b) at least above or below the feed plane there is arranged a spraying device (11 or 13) connected to a connection for supplying a liquid, with an effective region extending over the whole width of the circuit board (1), such that when operating this the circuit board (1) which is pushed forward is sprayed with liquid in a region located close to the inlet side element (6b) and extending over the whole width of the board (1).

6. A device according to claim 5, characterised in that on the inlet side above as well as below the feed plane there is provided a spray device (11, 13).

7. A device according to claim 5 or 6, in that the spray devices (11,13) are able to be activated selectively either forwards or in pulses, during the running through of the board (1).

8. A device according to one of claims 5 to 7, characterised in that the activation of the spray devices (11, 13) occurs through a control device (17) by way of valves (14, 15) inserted in the supply line.

9. A device according to one of claims 5 to 7, characterised in that the spray devices (11, 13) are able to be activated, by way of a control device (17), with compressed gas, e.g. compressed air.

10. A device according to claim 8 or 9, characterised in that the spray devices (11, 13) are connected to a connection for supplying water.

**Revendications**

1. Procédé pour déposer une couche de soudure sur des surfaces métalliques ou métallisées, notamment sur des surfaces de composants (1) pour des applications électrotechniques, ces surfaces étant, après le dépôt d'un flux, alimentées en la soudure par immersion dans de la soudure liquide (7), caractérisé en ce qu'il consiste à alimenter, en plus, les surfaces peu avant le contact avec la soudure (7) liquide, en un liquide dont le point d'ébullition est inférieur à celui de la soudure (7) liquide, et qui, dès qu'il vient en contact avec la soudure, ne pénètre pas dans le flux, mais s'évapore.

2. Procédé suivant la revendication 1, pour déposer une couche de soudure sur les surfaces métalliques d'une plaquette à circuits imprimés (1), non équipée, les surfaces métalliques étant, après le dépôt d'un flux sur la plaquette (1), alimentées en la soudure par immersion de la plaquette (1) dans de la soudure (7) et en la retirant ensuite, caractérisé en ce qu'il consiste à alimenter en le liquide les côtés comportant des surfaces métalliques de la partie de la plaquette (1) qui n'a pas encore été immergée, dans une région se trouvant peu avant l'introduction dans la soudure liquide et s'étendant sur toute la largeur de la plaquette (1).

3. Procédé suivant la revendication 1, pour relier des pastilles métallisées sur un substrat à des éléments de raccordement, les éléments de raccordement étant d'abord fixés mécaniquement aux pastilles et, après le dépôt d'un flux, étant reliés de manière conductrice de l'électricité aux pastilles par immersion dans de la soudure liquide, caractérisé en ce qu'il consiste à alimenter les éléments de raccordement et les pastilles en le liquide peu avant la venue en contact avec la soudure liquide.

4. Procédé suivant l'une des revendications précédentes, caractérisé en ce qu'il consiste à utiliser de l'eau comme liquide.

5. Installation pour la mise en oeuvre du procédé suivant la revendication 2, comprenant un réservoir contenant de la soudure fondue et une structure (2) en forme de cheminée qui dépasse de ce réservoir et à l'intérieur de laquelle de la soudure est transportée vers le haut, à partir du réservoir (3), en une quantité telle qu'il se forme, audessus de l'ouverture de sortie de la structure (2), une vague de soudure liquide, avec laquelle la plaquette à circuits imprimés (1) déplacée horizontalement est mise en contact, une tôle de guidage (5) qui est au moins en partie sensiblement parallèle au plan d'avance de la plaquette à circuits imprimés traversant la vague de soudage, et dont l'angle d'inclinaison et la distance par rapport au plan d'avance peuvent être réglés à volonté, étant prévue au bord supérieur d'au moins celles des parois latérales (2b) de la structure (2) s'étendant transversalement à la direction d'avance qui est tournée vers le côté d'entrée (E), au moins un élément (6a, 6b), disposé transversalement à la direction d'avance de la plaquette à circuits imprimés (1), étant prévu à la fois du côté de l'entrée (E) et du côté de la sortie (A) juste au-dessus du plan d'avance, ces éléments (6a, 6b) servant lors du passage de la plaquette à circuits imprimés (1), d'une part à enlever la soudure et, d'autre part formant une limitation pour le tapis de soudure se produisant du côté supérieur de la plaquette à circuits imprimés (1), caractérisée en ce qu'outre un dispositif pour déposer un flux, il est prévu, dans la région de l'élément (6b) se trouvant du côté de l'entrée, au moins au-dessus ou en-dessous du plan d'avance, un dispositif de projection (11 et 13) communiquant avec un raccord pour l'amenée d'un liquide et ayant un domaine d'action s'étendant sur toute la largeur de la plaquette à circuits imprimés (1) de manière à projeter, lors de son fonctionnement, du liquide sur une partie de la plaquette à circuits imprimés (1) avancée, qui se trouve à proximité devant l'élément du côté de l'entrée (6b) et qui s'étend sur toute la largeur de la plaquette (1).

6. Installation suivant la revendication 5, caractérisée en ce qu'il est prévu un dispositif de projection (11, 13), du côté de l'entrée, à la fois au-dessus et endessous du plan d'avance.

7. Installation suivant la revendication 5 ou 6, caractérisée en ce que les dispositifs de projection (11, 13) peuvent être mis en fonctionnement à volonté, d'une manière permanente ou par impulsions, pendant le passage de la plaquette (1).

8. Installation suivant l'une des revendications 5 à 7, caractérisée en ce que la mise en fonctionnement des dispositifs de projection (11, 13) s'effectue par un dispositif de commande (17), par l'intermédiaire de vannes (14, 15) montées dans le conduit d'amenée.

9. Installation suivant l'une des revendications 5 à 7, caractérisée en ce que les dispositifs de projection (11, 13) peuvent être mis en fonctionnement par un dispositif de commande (17), à l'aide de gaz sous pression, par exemple d'air comprimé.

10. Installation suivant la revendication 8 ou 9, caractérisée en ce que les dispositifs de projection (11, 13) communiquent avec un raccord destiné à amener de l'eau.